# EUROPEAN PATENT APPLICATION

(11) **EP 4 502 482 A1**
(43) Date of publication of application: **05.02.2025**
(21) Application number: 23780790.4
(22) Date of filing: 29.03.2023
(51) Int. Cl.: F24F 11/52, H05K 5/02

(54) **AIR CONDITIONER CONTROLLER**

(30) Priority: 30.03.2022 JP 2022057582
(71) Applicant: Fujitsu General Limited, Kawasaki-shi, Kanagawa 213-8502 (JP)
(72) Inventor: KUDO, Takayuki, Kawasaki-shi, Kanagawa 213-8502 (JP)
(74) Representative: TBK
(86) International application number: PCT/JP2023/013010
(87) International publication number: WO 2023/190782

(57) **Abstract**

Provided is an air conditioner controller having a high visibility of the operation state of an air conditioner and a high design quality as part of an interior decoration in harmony with a surrounding environment. The controller includes a main body including: a display unit disposed on a front surface of the controller; a display unit holder configured to hold the display unit; and a case including a holding member configured to support the display unit holder, and a protection member provided forward of the holding member and configured to cover an end surface of the display unit which end surface connects a front surface of the display unit to a back surface of the display unit. The display unit holder includes a rib provided along a direction where an outer periphery of the display unit extends, the rib projecting in a direction intersecting with the front surface of the display unit, and the case has a groove into which the rib is fitted.

## Description

### Technical Field

This disclosure relates to an air conditioner controller disposed in a room or the like, for example.

### Background Art

In the related art, a controller fixed to an attachment surface such as a wall surface of a house, connected by wire or by radio to an air conditioner disposed in a room, and used to operate the air conditioner is proposed. In recent years, such a controller has been operated by an application installed in a smartphone, or an indoor unit of the air conditioner has been controlled by a schedule timer function or the like of the controller (for example, PTL 1). The controller is demanded to have operability and a high appearance quality as a product in harmony with an interior decoration such as walls or furniture.

### Citation List

### Patent Literature

PTL 1: JP 2014-190566 A

### Summary of Invention

### Technical Problem

This disclosure is achieved in view of such a problem, and an object of this disclosure is to provide an air conditioner controller having a high appearance quality as a product in harmony with an interior decoration such as walls or furniture.

### Solution to Problem

In order to achieve the above object, an air conditioner controller according to one aspect of this disclosure includes a main body including: a display unit disposed on a front surface of the air conditioner controller; a display unit holder configured to hold the display unit; and a case including a holding member configured to support the display unit holder, and a protection member provided forward of the holding member and configured to cover an end surface of the display unit which end surface connects a front surface of the display unit to a back surface of the display unit. The display unit holder includes a rib provided along a direction where an outer periphery of the display unit extends, the rib projecting in a direction intersecting with the surface of the display unit, and the case has a groove into which the rib is fitted.

### Advantageous Effects of Invention

With one aspect of this disclosure, it is possible to achieve an air conditioner controller having a high appearance quality as a product in harmony with an interior decoration such as walls or furniture.

### Brief Description of Drawings

FIG. 1 is a schematic view illustrating an installation state of an air conditioner controller according to this disclosure;
FIG. 2 is an appearance perspective view illustrating an exemplary configuration of the air conditioner controller according to this disclosure;
FIG. 3 is a front view illustrating an exemplary configuration of the air conditioner controller according to this disclosure;
FIG. 4 is an exploded view illustrating an exemplary configuration of a main body of the air conditioner controller according to this disclosure;
FIG. 5 is a perspective view illustrating a back-surface configuration of a display unit of the air conditioner controller according to this disclosure;
FIG. 6 is a sectional view illustrating an exemplary configuration of an air conditioner controller according to a first embodiment of this disclosure;
FIG. 7 is an expanded sectional view illustrating an exemplary configuration of an upper portion of the air conditioner controller according to the first embodiment of this disclosure;
FIG. 8A is a rear view illustrating an example of a rib arrangement of a display unit holder used for the air conditioner controller according to the first embodiment of this disclosure;
FIG. 8B is a rear view illustrating an example of the rib arrangement of the display unit holder used for the air conditioner controller according to the first embodiment of this disclosure;
FIG. 8C is a rear view illustrating an example of the rib arrangement of the display unit holder used for the air conditioner controller according to the first embodiment of this disclosure;
FIG. 8D is a rear view illustrating an example of the rib arrangement of the display unit holder used for the air conditioner controller according to the first embodiment of this disclosure;
FIG. 8E is a rear view illustrating an example of the rib arrangement of the display unit holder used for the air conditioner controller according to the first embodiment of this disclosure;
FIG. 8F is a rear view illustrating an example of the rib arrangement of the display unit holder used for the air conditioner controller according to the first embodiment of this disclosure;
FIG. 8G is a rear view illustrating an example of the rib arrangement of the display unit holder used for the air conditioner controller according to the first embodiment of this disclosure;
FIG. 8H is a rear view illustrating an example of the rib arrangement of the display unit holder used for the air conditioner controller according to the first embodiment of this disclosure; and
FIG. 9 is a sectional view illustrating another exemplary configuration of the air conditioner controller according to the first embodiment of this disclosure.

### Description of Embodiments

The following describes this disclosure based on embodiments, but the following embodiments do not limit the invention according to Claims. In addition, all combinations of features described in the embodiments may not be essential to the solution of the invention.

With reference to the drawings, the following describes each embodiment of this disclosure.

### [Configuration of Air Conditioner Controller]

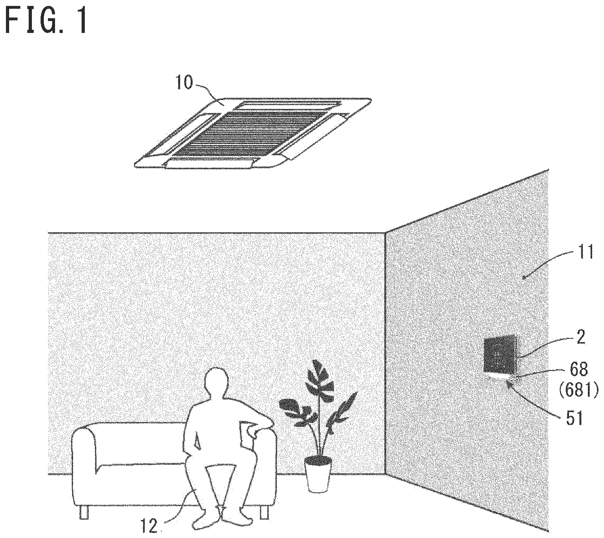

The following describes an air conditioner controller according to an embodiment of this disclosure with reference to FIGS. 1 to **9****.** The present embodiment deals with a controller fixed to an attachment surface such as a wall surface in a house and configured to control an indoor unit of an air conditioner.

As illustrated in FIG. 1, an air conditioner controller 2 according to this disclosure is connected to an air conditioner 10 by wire or by radio to send an operation control signal to the air conditioner 10 and has a function to display an operation state of the air conditioner 10. The air conditioner 10 may be a ceiling-embedded air conditioner as illustrated in FIG. 1, for example, or may be a duct-type air conditioner (not illustrated in FIG. 1), and the type of the air conditioner is not limited. The controller 2 is attached to an attachment surface 11 such as a wall surface in a room by an attachment member (not illustrated) such as a screw or a double-stick tape.

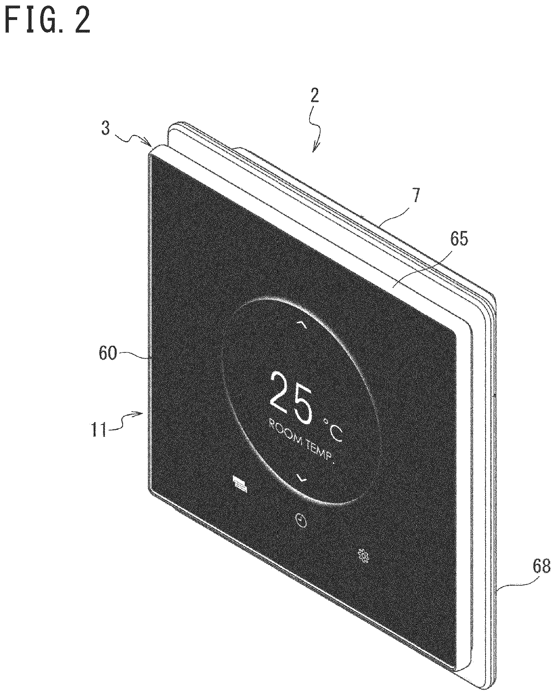

FIG. 2 is an appearance perspective view illustrating an appearance configuration of the controller 2. As illustrated in FIG. 2, the controller 2 includes a display unit 60 disposed on a front surface of the controller 2. The controller 2 described in the present embodiment may also include a screen panel 68 attached to a main body 3. Here, FIG. 2 illustrates one exemplary configuration in a case where the main body 3 has a hollow rectangular solid shape. The main body 3 of the controller 2 is attached to a base 7 fixed to the attachment surface 11 (see FIG. 1).

The structure of the main body 3 of the air conditioner controller 2 will be described below in detail.

### <Main Body>

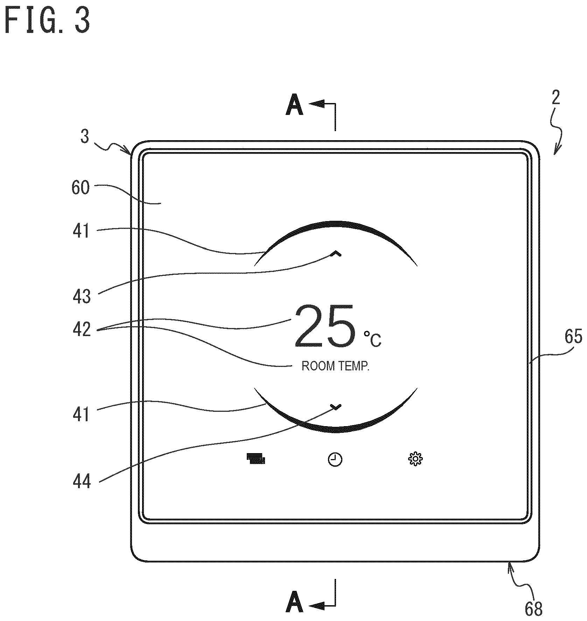

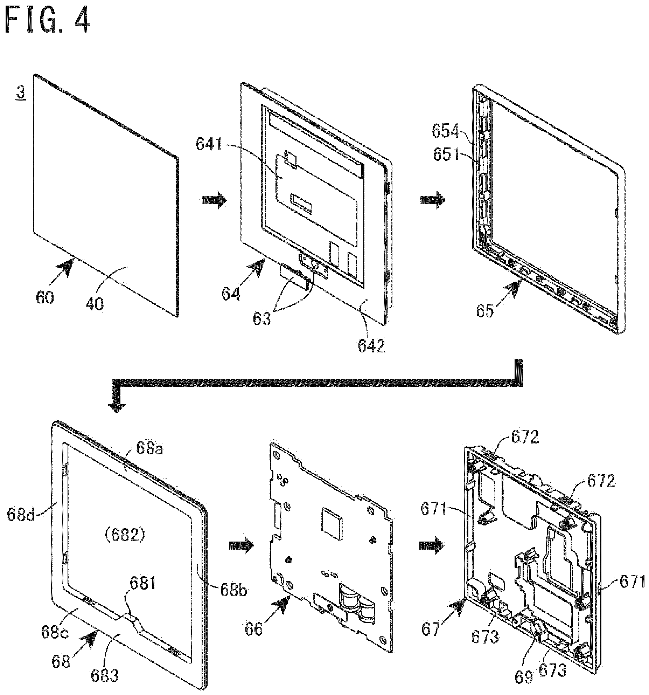

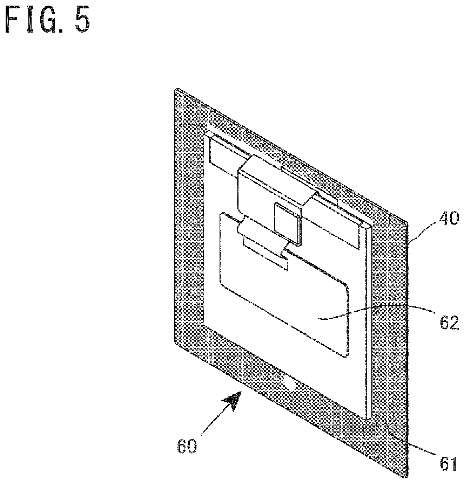

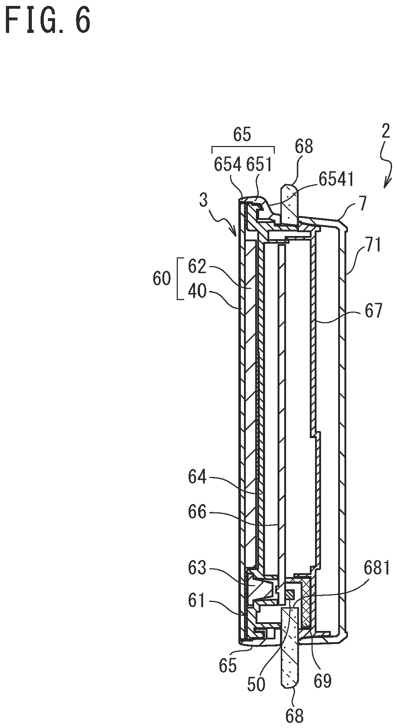

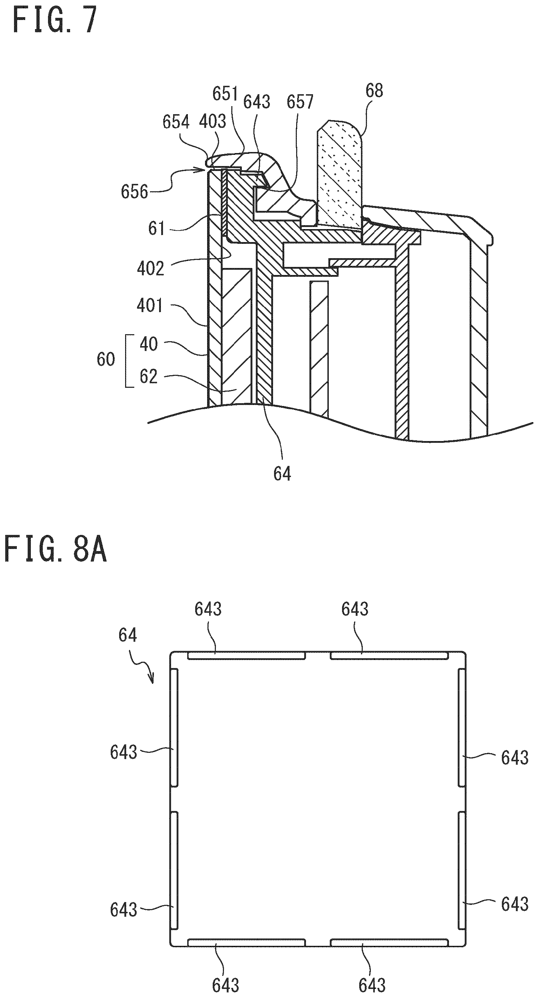

FIG. 3 is a front view of the controller 2 and illustrates an example of the display unit 60. Note that, in FIG. 3, black and white on a screen are reversed for illustration. FIG. 4 is an exploded perspective view illustrating an exemplary configuration of the main body 3. FIG. 5 is a perspective view to describe the configuration of the back-face side of the display unit 60 of the controller 2. FIG. 6 is a sectional view illustrating an exemplary configuration of the main body 3 and illustrates a section A-A in FIG. 3. FIG. 7 is an expanded sectional view illustrating a detailed configuration of an upper portion of the controller 2. FIGS. 8A to 8H are schematic views to describe a position to provide a rib 643 in a display unit holder 64.

As illustrated in FIGS. 4, 6, the main body 3 includes the display unit 60, the display unit holder 64, and a case 65. Further, the main body 3 may include the screen panel 68 and a substrate holder 67.

The following describes constituents of the main body 3.

### (Display Unit)

The display unit 60 is provided on the front surface of the controller 2 and has a function to display operation details of the air conditioner 10 and a function of a touch panel to operate the air conditioner 10. As illustrated in FIG. 3, an operation state of the air conditioner 10 is displayed on the display unit 60. Further, as illustrated in FIGS. 4, 5, the display unit 60 includes a display screen 62, and a panel 40 disposed on the front surface of the display screen 62 and having an external shape larger than that of the display screen 62. The display screen 62 is fixed to the panel 40 by a fixing member 61 such as an adhesive sheet.

The display screen 62 is a liquid crystal screen, for example. As illustrated in FIG. 3, the display screen 62 displays a pattern, a text, or the like indicative of an operation state and an operation region of the controller 2 (details will be described later).

The panel 40 is made of a translucent material to allow the display on the display screen 62 to pass therethrough to the front surface of the controller 2. More specifically, the panel 40 is a translucent panel made of a translucent material such as glass or a resin material, e.g., colored or colorless acrylic, or the like, and may be a half mirror including a reflection coating on the translucent panel. In a case where such a panel 40 is provided, the display unit 60 causes a text, a number, a pattern, or the like displayed on the display screen 62 to pass through the panel 40 to the front surface of the controller 2 at the time when the display screen 62 emits light. Further, the panel 40 reflects a color, a design, a shape, or the like of wallpaper or an interior decoration in the room, so that the controller 2 can be harmonized with the wall surface or the interior decoration in the room. The panel 40 can also reduce the presence of the controller 2, so that a text, a number, a pattern, or the like on the display screen 62 can be displayed as if it floats. As illustrated in FIG. 5, the fixing member 61 for fixing the panel 40 to the display unit holder 64 is provided on the back surface of the panel 40.

As illustrated in FIG. 3, large circular arcs 41 displayed in the center of the display unit 60 are indications indicative of the air conditioner 10 being operating and is not displayed at the time when the air conditioner 10 is stopped. The display unit 60 displays a current room temperature (for example, 25°c) 42 together with a text "ROOM TEMP." in the center between the circular arcs 41 at the time when the air conditioner 10 operates.

Further, an up arrow 43 and a down arrow 44 in respective circular arcs 41 are displayed in an operation region to be operated when a desired temperature is changed. For example, when the up arrow 43 or the down arrow 44 is tapped, the text "ROOM TEMP." and the current room temperature 42 on the display unit 60 are changed to a text "RRESET TEMP." and a desired temperature (not illustrated in FIG. 3). When the up arrow 43 or the down arrow 44 is tapped again, the display unit 60 changes a displayed number indicative of the desired temperature. For a while after the desired temperature is changed, the display unit 60 changes the display from the text "RRESET TEMP." and the desired temperature to the text "ROOM TEMP." and the current room temperature 42. Note that the operation on the up arrow 43 and the down arrow 44 is not limited to a tap operation, and the desired temperature may be controlled by a swipe operation.

### (Case)

As illustrated in FIGS. 4, 6, the case 65 has a frame shape and includes a holding member 651 for supporting the display unit holder 64. Further, as illustrated in FIG. 7, the case 65 includes a protection member 654 provided forward of the holding member 651 and covering an end surface of the display unit 60, that is, an end surface 403 of the panel 40 which end surface 403 connects a front surface 401 to a back surface 402. The protection member 654 may make contact with the end surface 403 of the panel 40.

The protection member 654 may also cover the end surface 403 via a gap 656. The gap 656 is formed between the protection member 654 and the end surface 403 such that the outer periphery of the display unit holder 64 is placed outside the outer periphery of the display unit 60 in a front view. In a case where the gap 656 is formed between the protection member 654 and the end surface 403, when an impact is applied to the case 65 from outside, the holding member 651 is received by the display unit holder 64, thereby making it possible to restrain the holding member 651 from deforming into the main body 3 across the display unit holder 64 (a rib 643). This can prevent the impact from being applied to the display unit 60 from outside the case 65 and reduce the impact to be applied to the display unit 60, thereby making it possible to restrain the display unit 60 from being damaged. That is, it is preferable that the protection member 654 cover the whole end surface 403 of the panel 40 (part of the display unit 60) disposed on the front surface of the display screen 62 and having an external shape larger than that of the display screen 62. This makes it possible to improve an effect of restraining damage for the display unit 60.

It is preferable that the protection member 654 be formed to be thinner in thickness as it goes toward the front side of the case 65, that is, toward a distal end of the protection member 654. It is preferable that the distal end of the protection member 654 have a thickness of 1 mm or less, for example. Hereby, the case 65 provided to surround the outer periphery of the display unit 60 is unnoticeable in a front view of the controller 2. When the display unit 60 including the panel 40 reflects the color, design, shape, or the like of the wallpaper or the interior decoration in the room, the controller 2 harmonizes with the wall surface or the interior decoration in the room. This makes the case 65 unnoticeable, thereby making it possible to improve the harmoniousness of the controller 2 with the wall surface or the interior decoration in the room.

Further, as illustrated in FIG. 6, the case 65 has a groove 657 at a position facing the display unit holder 64. The rib 643 (described later) provided in the display unit holder 64 is fitted into the groove 657 provided in the case 65.

The case 65 has a stepped surface 6541 recessed inwardly from the back surface of the holding member 651. Since the case 65 has the stepped surface 6541, a user 12 feels that the main body 3 is thin in thickness, and the user 12 can have such an impression that the main body 3 floats on the attachment surface 11, thereby improving the design quality of the controller **2.**

### (Display Unit Holder)

The display unit holder 64 is a member for holding the display unit 60. The display unit holder 64 includes a recessed portion 641 formed in the center of the display unit holder 64 such that the display screen 62 is stored therein, and a panel support 642 formed around the recessed portion 641 and supporting the back surface of the panel 40. Further, the display unit holder 64 may include an illumination level sensor light receiving section 63 in a lower end portion of the panel support 642. The display unit holder 64 is fixed to the panel 40 of the display unit 60 by the fixing member 61, for example.

The display unit holder 64 includes the rib 643 provided in at least part of an outer peripheral edge of the panel support 642 along a direction where the outer periphery of the display unit 60 extends. It is preferable that the rib 643 have an elongated shape extending along the direction where the outer periphery of the display unit 60 extends. This can increase an effect to restrain the protection member 654 from expanding outward in comparison with a case where ribs formed in a small projection shape are arranged at intervals in the direction where the outer periphery of the display unit 60 extends. It is also preferable that the rib 643 project from the outer peripheral edge of the display unit holder 64. This is because, as the rib 643 is provided at a position closer to the outer peripheral edge of the display unit holder 64, the effect to restrain the protection member 654 from expanding outward becomes higher. It is preferable that the rib 643 provided in the display unit holder 64 project in a direction intersecting with the surface of the display unit 60 and, for example, project in a direction toward the back surface of the controller 2 as illustrated in FIG. 7.

As described above, the protection member 654 covering the end surface 403 of the panel 40 is formed thinly to improve the interior quality of the controller 2. Accordingly, when the strength of the protection member 654 on the front side of the case 65 is insufficient, the protection member 654 easily expands in a direction distanced from the end surface 403 of the panel 40 which end surface 403 is an end surface of the display unit 60, that is, directions (vertical and horizontal directions in FIG. 3, for example) parallel to the surface of the display unit 60. Hereby, the width of the gap 656 between the display unit 60 and the case 65 becomes wider than a designed width, and the width of the gap 656 becomes ununiform, thereby resulting in that the gap 656 sticks out, or the panel support 642 of the display unit holder 64 is easily observable from outside the controller 2. In view of this, when the display unit holder 64 includes the rib 643 projecting in the direction intersecting with the surface of the display unit 60, it is possible to restrain the protection member 654 of the case 65 from expanding in the directions parallel to the surface of the display unit 60. Hereby, even when the protection member 654 is formed thinly, the gap 656 between the display unit 60 and the case 65 is unnoticeable, thereby improving the appearance quality as a product. As a result, the controller 2 has a high design quality as part of the interior decoration.

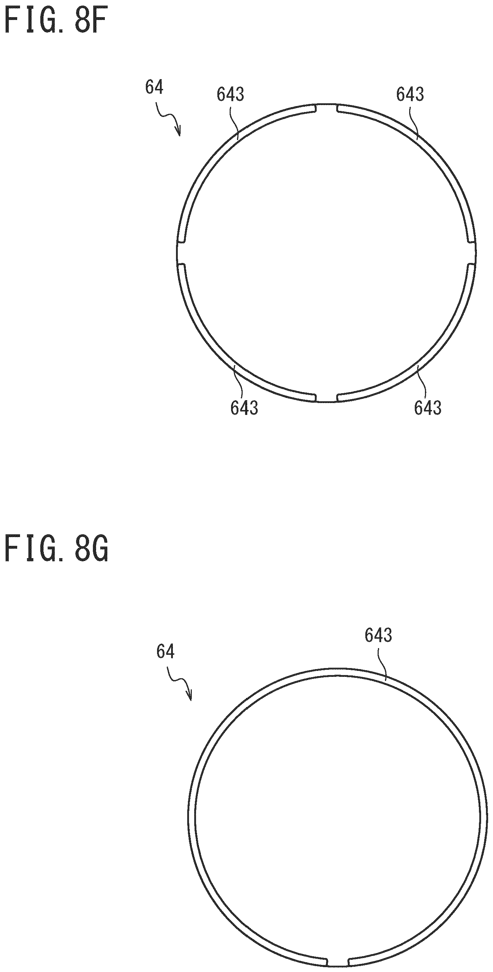

FIGS. 8A to 8H are schematic views to describe a position to provide the rib 643 in a rear view of the display unit holder 64. FIGS. 8A to 8E each illustrate an example in which the display unit 60 and the display unit holder 64 have a square shape in a front view, and FIGS. 8F to 8H each illustrate an example in which the display unit 60 and the display unit holder 64 have a circular shape in a front view.

As described above, the display unit holder 64 includes the rib 643 on at least part of the outer peripheral edge of the panel support 642.

For example, as illustrated in FIG. 8A, the display unit holder 64 may include a plurality of ribs 643 on the outer peripheral edge of the panel support 642.

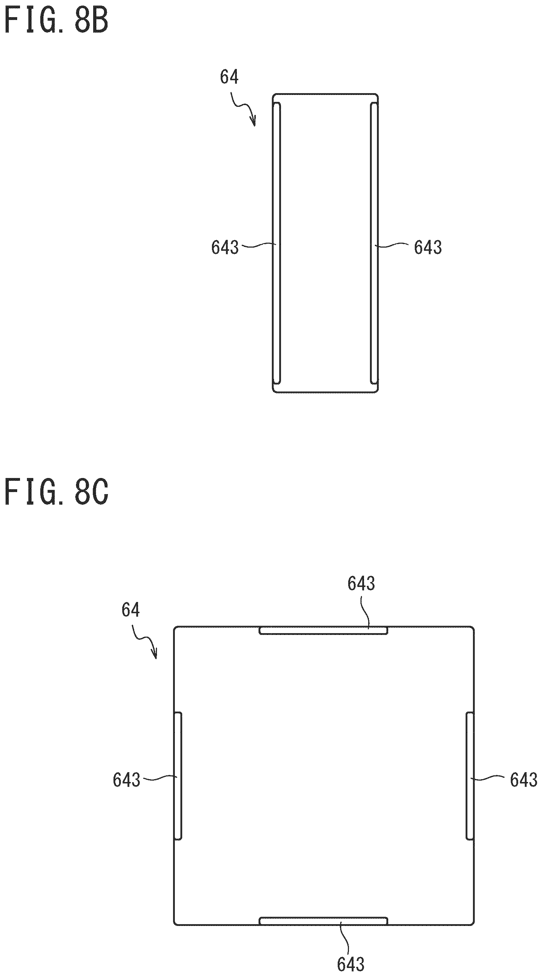

Further, as illustrated in FIG. 8B, in a case where a pair of sides of the case 65 which sides face each other are short in length to such an extent that the protection member 654 can hardly expand, the display unit holder 64 may include no rib 643 on the pair of short sides. Here, the meaning of the pair of sides being "short to such an extent that the protection member can hardly expand" is that the pair of sides of the case 65 which sides facing each other are short in length to such an extent that the user 12 cannot recognize that the width of the gap 656 between the display unit 60 and the case 65 is wider than a designed width and the width of the gap 656 is ununiform.

As illustrated in FIG. 8C, it is preferable that the display unit holder 64 include the ribs 643 at least at respective positions facing respective intermediate portions of a plurality of sides of the display unit 60, that is, in respective intermediate portions of a plurality of sides of the display unit holder 64.

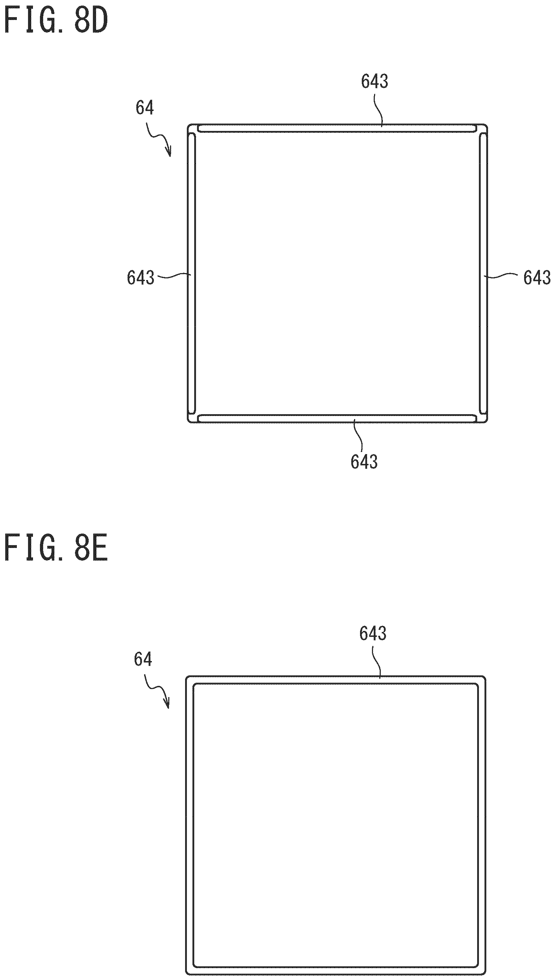

Further, as illustrated in FIG. 8D, it is preferable that the display unit holder 64 include the ribs 643 provided at respective positions facing respective linear portion of the plurality of sides of the display unit 60, that is, in linear portions of the outer periphery of the display unit holder 64.

Further, as illustrated in FIG. 8E, it is further preferable that the display unit holder 64 include the rib 643 provided at a position facing the whole outer periphery of the display unit 60, that is, in the whole outer periphery of the display unit holder 64.

Hereby, the rib 643 of the display unit holder 64 is fitted into at least a portion of the protection member 654 which portion easily expands (an intermediate portion of each of the plurality of sides of the display unit holder 64), thereby restraining the protection member 654 from expanding outward. Besides, as the case 65 is fitted into the display unit holder 64 with a larger range, the strength of the case 65 improves, and the tolerance to impact from outside also improves.

Further, in a case where the display unit 60 and the display unit holder 64 have a circular shape in a front view, the protection member 654 can hardly expand in comparison with a case where the display unit 60 and the display unit holder 64 have a polygonal shape, but when the display unit holder 64 is provided, the protection member 654 can further hardly expand.

For example, as illustrated in FIG. 8F, the display unit holder 64 having a circular shape includes a plurality of ribs 643 on part of the outer peripheral edge of the panel support 642.

Further, as illustrated in FIG. 8G, the display unit holder 64 having a circular shape may include one rib 643 disposed on part of the outer peripheral edge of the panel support 642 in such a manner as to project from most of the outer peripheral edge.

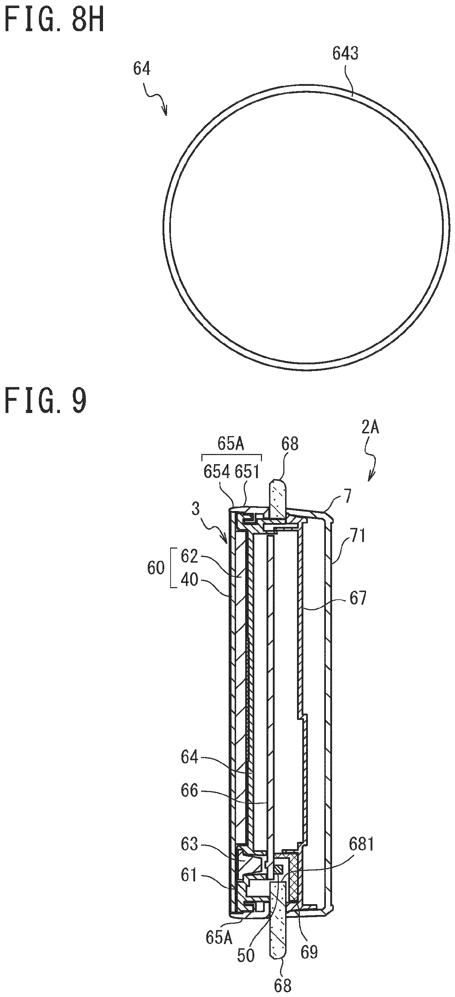

Further, as illustrated in FIG. 8H, it is preferable that the display unit holder 64 having a circular shape include the rib 643 on the whole outer peripheral edge of the panel support 642.

### (Substrate Holder)

The substrate holder 67 supports a substrate 66 together with the display unit holder 64. The substrate holder 67 includes detent receivers 671, 672 (described later) on the outer periphery of the substrate holder 67. Further, the substrate holder 67 includes a light source case 69 for protecting a light source 50, in a lower portion of the substrate holder 67. The light source case 69 is formed such that its central portion rises and is disposed to cover the light source 50 such as an LED mounted on the substrate 66.

The substrate holder 67 has a threaded hole 673 (see FIG. 4) and is fixed to a base 7 by screw (not illustrated).

### <Base>

The base 7 has a box shape open on a side facing the attachment surface 11 (see FIG. 1) of a wall or the like. The base 7 includes a back surface portion 71 in contact with the attachment surface 11. At the time of installation of the controller 2, the base 7 is first attached to the attachment surface 11. After that, the main body 3 and the screen panel 68 are attached to the base 7 fixed to the attachment surface 11.

### <Screen Panel>

The screen panel 68 is made of a translucent material, for example. Light emitted from the light source 50 (see FIG. 6) provided in the main body 3 travels in the screen panel 68, and light 51 (see FIG. 1) is applied to part of the screen panel 68. The light source 50 emits light with different colors corresponding to operation modes of the air conditioner 10. For example, the light source emits red light at the time of heating operation, blue light at the time of cooling operation, and green light at the time of dehumidifying operation, and the light source emits white light or no light at the time of operation stop. Hereby, even when the user 12 is distanced from the controller 2, the user 12 can find by visual observation whether or not the air conditioner 10 is operating or not, in which operation mode the air conditioner 10 operates, or the like. This accordingly improves the visibility of the operation state of the air conditioner 10.

The screen panel 68 as a plate-shaped member may be provided in a standing manner from a lateral surface of the main body 3. The screen panel 68 is disposed between the base 7 and the stepped surface 6541 of the case 65 of the main body 3. The screen panel 68 is a square-shaped frame body and includes an upper edge portion 68a, a right edge portion 68b, a lower edge portion 68c, and a left edge portion 68d. The screen panel 68 has a through-hole formed on a central side of the screen panel 68. An extension portion extended from the main body is passed through the through-hole. In the present embodiment, the screen panel 68 having an opening 682 (the through-hole) open squarely is formed in an annular shape. Then, the screen panel 68 is disposed between the case 65 and the base 7, so that the main body 3 supports the screen panel 68. The screen panel 68 is made of a transparent material and is formed to be larger than the case 65 in a front view. Particularly, the lower edge portion 68c is formed to largely extend downward such that the lower edge portion 68c of the screen panel 68 projects from the case 65 to such an extent that the lower edge portion 68c is observable in a front view, and part of the lower edge portion 68c serves as a light-emission display surface 683. The front surface and the back surface of the screen panel 68 may be subjected to grain finish (not illustrated). A light guiding portion 681 (see FIG. 4) having a trapezoidal shape and projecting into the opening 682 so as to make contact with the lower end of the light source 50 in the light source case 69 is provided in the center of the lower edge portion 68c.

### [Modifications]

The present embodiment has described the configuration in which the case 65 has the stepped surface 6541 recessed inwardly from the back surface of the holding member 651. However, the present invention is not limited to such a configuration.

For example, as illustrated in FIG. 9, a controller 2A may be configured such that a case 65A does not have the stepped surface 6541, and the holding member 651 including no step is formed toward the back surface portion 71 (a surface in contact with the attachment surface 11) of the main body 3.

The embodiment of this disclosure has been described above, but the above embodiment describes devices or methods to embody the technical idea of this disclosure, and the technical idea of this disclosure does not limit a material, a shape, a structure, an arrangement, and the like of a constituent component. Various changes can be added to the technical idea of this disclosure within a technical scope defined by claims described in Claims.

### Reference Signs List

- 2, 2A: controller
- 3: main body
- 7: base
- 10: air conditioner
- 11: attachment surface
- 12: user
- 40: panel
- 401: front surface
- 402: back surface
- 403: end surface
- 41: circular arc
- 42: room temperature
- 43: up arrow
- 44: down arrow
- 50: light source
- 60: display unit
- 61: fixing member
- 62: display screen
- 64: display unit holder
- 641: recessed portion
- 642: panel support
- 643: rib
- 65, 65A: case
- 651: holding member
- 654: protection member
- 6541: stepped surface
- 656: gap
- 657: groove
- 66: substrate
- 67: substrate holder
- 671: detent receiver
- 672: detent receiver
- 68: screen panel
- 68a: upper edge portion
- 68b: right edge portion
- 68c: lower edge portion
- 68d: left edge portion
- 681: light guiding portion
- 682: opening
- 683: light-emission display surface
- 69: light source case
- 71: back surface

## Claims

1. An air conditioner controller comprising:
a main body including
a display unit disposed on a front surface of the air conditioner controller,
a display unit holder configured to hold the display unit,
a case including a holding member configured to support the display unit holder, and a protection member provided forward of the holding member and configured to cover an end surface of the display unit which end surface connects a front surface of the display unit to a back surface of the display unit, wherein:
the display unit holder includes a rib provided along a direction where an outer periphery of the display unit extends, the rib projecting in a direction intersecting with the surface of the display unit; and
the case has a groove into which the rib is fitted.

2. The air conditioner controller according to claim 1, wherein the rib of the display unit holder includes a rib projecting toward a back-surface direction.

3. The air conditioner controller according to claim 2, wherein the rib of the display unit holder includes ribs provided at least at respective positions facing respective intermediate portions of a plurality of sides of the display unit.

4. The air conditioner controller according to claim 3, wherein the rib of the display unit holder includes ribs provided at respective positions facing respective linear portions of the plurality of sides of the display unit.

5. The air conditioner controller according to claim 4, wherein the rib of the display unit holder includes a rib provided at a position facing the whole outer periphery of the display unit.

6. The air conditioner controller according to any one of claims 1 to 5, wherein:
the display unit includes
a display screen, and
a panel disposed on a front surface of the display screen and formed to be larger than the display screen; and
the display unit holder includes
a recessed portion formed in a center of the display unit holder such that the display screen is stored in the recessed portion, and
a panel support formed around the recessed portion and configured to support a back surface of the panel.

7. The air conditioner controller according to any one of claims 1 to 6, wherein the protection member is formed to be thinner in thickness toward a front side of the case.

8. The air conditioner controller according to any one of claims 1 to 7, wherein:
the display unit holder has an outer periphery placed outside the outer periphery of the display unit in a front view; and
the protection member covers the end surface via a gap.
